Europäisches Patentamt

(19) European Patent Office

Office européen des brevets

(11) Numéro de publication: **0 201 970**
B1

(12) **FASCICULE DE BREVET EUROPEEN**

(45) Date de publication du fascicule du brevet:
28.02.90

(21) Numéro de dépôt: **86200785.3**

(22) Date de dépôt: **05.05.86**

(51) Int. Cl.⁴: **G11C 19/28**, G11C 27/04

(54) **Dispositif à transfert de charges muni d'organes selfiques.**

(30) Priorité: **14.05.85  FR 8507283**

(43) Date de publication de la demande:
**20.11.86 Bulletin 86/47**

(45) Mention de la délivrance du brevet:
**28.02.90 Bulletin 90/9**

(84) Etats contractants désignés:
**DE FR GB IT NL**

(56) Documents cités:
**US-A- 3 921 195**
**US-A- 3 975 753**

(73) Titulaire: **LABORATOIRES D'ELECTRONIQUE PHILIPS,
3, Avenue Descartes, F-94450 Limeil-Brévannes(FR)**
(84) Etats contractants désignés: **FR**

(73) Titulaire: **N.V. Philips' Gloeilampenfabrieken,
Groenewoudseweg 1, NL-5621 BA Eindhoven(NL)**
(84) Etats contractants désignés: **DE GB IT NL**

(72) Inventeur: **Boutigny, Pierre-Henri, Société Civile
S.P.I.D. 209, rue de l'Université, F-75007 Paris(FR)**

(74) Mandataire: **Landousy, Christian et al, Société Civile
S.P.I.D. 209, Rue de l'Université, F-75007 Paris(FR)**

ACTORUM AG

## Description

L'invention concerne les dispositifs à transfert de charges comprenant N éléments-mémoire dans lesquels les charges stockées sont transférées à l'aide de 2 ou 4 horloges issues d'un générateur d'horloges, les 2 ou 4 horloges étant appliquées sur chaque élément-mémoire à l'aide de 2 ou 4 plots de contact, sur chacun desquels apparaissent une capacité Ce entre plots voisins et une capacité Cs entre un plot et le substrat du dispositif à transfert de charges.

L'invention concerne également les applications de tels dispositifs à transfert de charges, par exemple dans le traitement du signal en oscilloscopie numérique, ou dans le traitement d'images.

Un dispositif à transfert de charges (DTC) est un registre à décalage pour des signaux analogiques. Sous sa forme la plus simple, il est formé d'un substrat monocristallin semiconducteur sur lequel sont placées différentes électrodes isolées du substrat par des couches d'oxydes. Le substrat est généralement du silicium et l'isolant est de l'oxyde de silicium. Sous chaque électrode apparaissent des paquets de charges, celles-ci étant injectées à l'aide d'un contact électrique sous le contrôle d'une horloge. Le dispositif à transfert de charges stocke les échantillons du signal sous la forme de paquets de charges, puis les transfère, en parallèle, jusqu'à un amplificateur de charges, tout en gardant les paquets de charges isolés les uns des autres. Selon les technologies utilisées, les transferts sont effectués à l'aide de deux, trois ou quatre électrodes consécutives pour chaque élément-mémoire. Sur ces électrodes sont appliqués des signaux d'horloges dont la tension varie périodiquement et qui ont deux trois ou quatre phases selon le nombre d'électrodes. Il se crée ainsi des puits de potentiel sous chaque électrode qui sont translatés progressivement sur toute la ligne d'éléments-mémoire produisant le mécanisme de transfert des charges d'une électrode vers la suivante.

Cependant, il y a lieu d'assurer une grande capacité de stockage de charges et de réduire les effets des états de surface. Pour cela la plus grande partie de la charge est transférée dans une zone à dopage élevé près de la surface sous l'action du champ électrique auto-induit et le reste des charges est transféré dans une zone plus profonde du cristal à dopage plus faible sous l'action d'un champ électrique externe. Il s'agit alors d'un dispositif à transfert de charges péristaltique (PCCD) qui peut encore avoir un rendement de transfert amélioré en effectuant un dopage profilé pour diminuer le rôle des états de surfaces. On obtient alors un dispositif à transfert de charges péristaltique profilé (P2CCD). Ces dispositifs ont un rendement de transfert atteignant 0,999999 et une fréquence maximale d'horloge de 1,5 GHz.

Les circuits pour la génération des quatre horloges d'un dispositif P2CCD à quatre phases doivent donc délivrer des signaux ayant des transitions très rapides entre les niveaux de tension et ceci pour des charges capacitives qui sont importantes. Ces charges capacitives ont des valeurs telles qu'aux fréquences supérieures, par exemple à 100 MHz, la réalisation du générateur d'horloges présente de grandes difficultés ce qui ne permet pas d'utiliser les dispositifs à transfert de charges aux environs de leurs propres fréquences maximales de fonctionnement.

Un tel dispositif à transfert de charges a été décrit dans l'article intitulé : "P2CCD in 60 MHz oscilloscope with digital image storage" de H. DOLLE-KAMP, L. ESSER, H. DE JONG, PHILIPS TECH. REV. (1982)vol. 40, n° 2/3, pages 55 à 68. Il y est décrit un oscilloscope utilisant un dispositif à transfert de charges effectuant l'échantillonnage et la mémorisation du signal d'entrée, puis le transfert des échantillons acquis vers un organe de sortie. Cet article montre que dans le cas d'un dispositif à transfert de charges de type P2CCD muni de quatre horloges, l'opération de transfert de charges ne peut guère dépasser des fréquences de fonctionnement supérieures à 180 MHz - alors que le DTC pourrait intrinsèquement fonctionner à 1,5 GHz - car les circuits de génération des horloges ne peuvent opérer à des fréquences plus élevées eu égard aux fortes impédances capacitives présentées par la zone de transport du DTC. Cette limite de 180 MHz peut être légèrement améliorée, mais au prix d'un très fort accroissement de la dissipation des circuits de génération des horloges, ce qui nuit aux applications elles-mêmes.

Par contre la génération d'horloges rapides, pour des impédances de charge qui sont sensiblement résistives, ne pose pas de grandes difficultés dans la gamme de fréquences envisagée.

Un but de l'invention est donc de déterminer une structure de dispositif à transfert de charges pour laquelle les impédances de charge, présentées par les connexions d'horloges du DTC au générateur de signaux d'horloges, sont sensiblement résistives.

Pour cela l'invention telle que définie dans le préambule est remarquable en ce qu'à chacun des 2 ou 4 plots de contact d'un élément-mémoire est connecté à une des extrémités de deux organes selfiques LA et LB, de telle sorte que l'autre extrémité de l'organe selfique LB étant chargée par une impédance de nature résistive Zc, l'impédance présentée par l'autre extrémité de l'organe selfique LA soit aussi de nature résistive.

Elle est également remarquable en ce que les plots de contact contrôlés par une même horloge sont regroupés entre eux, en chaîne, par groupes de transport, l'autre extrémité de l'organe selfique LB relié à un plot étant réunie à l'autre extrémité de l'organe selfique LA du plot suivant, la dernière autre extrémité du dernier organe selfique LB de chaque groupe de transport étant réunie à une impédance résistive de charge Zc.

Un dispositif à transfert de charges va présenter sur les connexions d'horloges des capacités parasites de différentes origines. Un dispositif à transfert de charges, avec par exemple 4 horloges h1, h2, h3, h4, présentes respectivement sur 4 électrodes consécutives p1, p2, p3, p4, va présenter, pour un élément-mémoire donné, des capacités d'interconnexion entre les électrodes p1 et p2, entre les électrodes p2 et p3, entre les électrodes p3 et p4, et entre les électrodes p4 et p'l, où p'l reçoit la même horloge que l'électrode p1 mais appartient à l'élément-mémoire suivant. De la même façon chaque électrode p1, p2, p3 ou p4 va présenter par rapport à la masse, et pour un élément-mémoire unique quatre capacités Cs.

Pour un élément-mémoire donné, il apparaît ainsi huit sources de capacités interconnectées entre elles. Lorsque tous les éléments-mémoire sont reliés en série, pour constituer par exemple un DTC avec 256 éléments-mémoire, la capacité totale devient élevée, et dans certains cas prohibitive, eu égard aux fréquences de fonctionnement considérées. Ainsi la capacité totale qui peut se présenter sur chaque connexion d'horloge peut être de 25 pF environ.

Pour réduire cette capacité totale, l'invention réalise l'interconnexion des éléments-mémoire reliés à la même horloge en associant à chaque plot de contact des organes selfiques qui compensent la charge capacitive afin que l'impédance présentée à l'entrée du dispositif à transfert de charges soit une impédance sensiblement résistive. Cette impédance résistive est l'impédance caractéristique du quadripole composée par l'impédance capacitive du plot et par les organes selfiques.

Tous les N éléments-mémoire consécutifs sont ainsi connectés entre eux, et le dernier à la charge résistive Zc, par les organes selfiques. Il est souhaitable de réunir deux organes selfiques LA et LB adjacents en un seul organe selfique. Le dispositif à transfert de charges possédant 4 phases et N éléments-mémoire, il y aura donc 4(N+1) éléments selfiques. Il est possible de réunir les N éléments-mémoire, chacun ayant 8 organes selfiques, selon un regroupement judicieux facilitant l'organisation du circuit et la réalisation des masques pour l'obtention du circuit intégré final. Ainsi les N éléments-mémoire sont organisés en j groupes de transport qui comportent chacun k éléments-mémoire avec $1 \leq j \leq N$ et $N \geq k \geq 1$.

Ce qui vient d'être indiqué pour un dispositif à transfert de charges à 4 phases s'applique à un dispositif à transfert de charges à 2 phases ; la symétrie des signaux d'horloge étant analogue.

Selon un mode préférentiel de réalisation les organes selfiques sont constitués d'une self obtenue à l'aide d'une configuration d'un dépôt conducteur présentant une self inductance, par exemple une spirale. Le dépôt conducteur spiralé est préférentiellement de même nature que le conducteur réalisant les interconnexions entre les électrodes d'horloges et les électrodes d'horloges elles-mêmes. Ainsi la réalisation des conducteurs spiralés, des électrodes d'horloges et des interconnexions entre les électrodes d'horloges peuvent être menées à l'aide du même masque.

Mais il est également possible de réaliser le dépôt conducteur sur un support isolant, d'y fixer le circuit intégré monolithique, et d'effectuer les interconnexions des organes selfiques avec le circuit intégré monolithique à l'aide de thermocompression ou autres.

L'invention sera mieux comprise à l'aide de la description détaillée suivante, illustrée à l'aide de figures, données à titre d'exemples non limitatifs, et qui représentent :

Figure 1 : une représentation schématique de deux éléments-mémoire d'un dispositif à transfert de charges (DTC) à quatre phases où sont figurées les capacités parasites.

Figure 2 : un schéma électrique équivalent représentant l'interconnexion de ces capacités parasites pour une cellule élémentaire.

Figure 3 : un diagramme des temps pour l'application des horloges.

Figure 4 : un schéma électrique équivalent représentant, selon l'invention, l'interconnexion des schémes électriques équivalents selon la figure 2 pour une suite de cellules élémentaires à l'aide d'inductances de liaison.

Figure 5 : un exemple d'organe selfique constitué par une inductance spiralée.

Figure 6 : un exemple d'interconnexion des organes selfiques avec chaque plot de contact.

Figure 7 : un exemple d'interconnexion des organes selfiques où r éléments-mémoire sont regroupés en j groupes de transport.

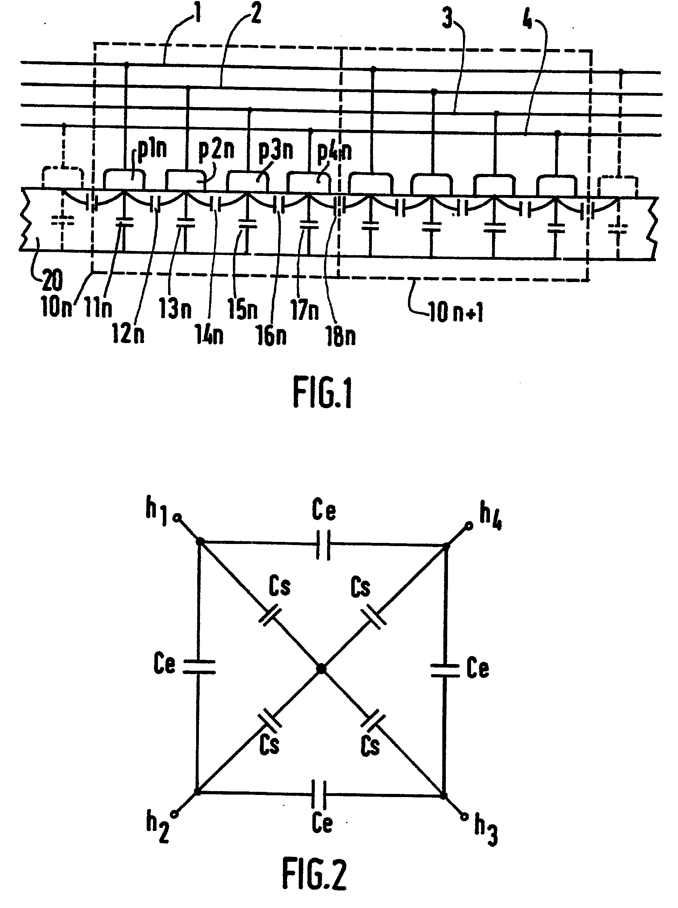

La figure 1 donne une représentation schématiquede deux éléments-mémoire consécutifs $10_n$, $10_{n+1}$ d'un dispositif à transfert de charges (DTC) à quatre horloges h1, h2, h3, h4, respectivement présentes sur les connexions 1, 2, 3, 4. L'élément-mémoire $10_n$ de rang n possède des électrodes $p1_n$, $p2_n$, $p3_n$, $p4_n$ reliées respectivement aux connexions 1, 2, 3, 4. Ces électrodes sont déposées en surface d'un substrat 20 dans lequel sont réalisés les différents dopages nécessaires à la réalisation d'un dispositif à transfert de charges (DTC) selon l'art connu.

Différentes capacités parasites apparaissent dans un tel DTC. Ce sont les capacités : $12_n$ entre les électrodes $p1_n$ et $p2_n$, $14_n$ entre les électrodes $p2_n$ et $p3_n$, $16_n$ entre les électrodes $p3_n$ et $p4_n$ et $18_n$ entre les électrodes $p4_n$ et $p1_{n+1}$. Ces capacités $12_n$, $14_n$, $16_n$ $18_n$ ont sensiblement des valeurs égales et sont appelées Ce dans la suite de la description. Entre chaque électrode et le substrat apparaissent des capacités $11_n$, $13_n$, $15_n$, $17_n$, là encore de valeur sensiblement identique pour chaque électrode, appelées Cs dans la suite de la description.

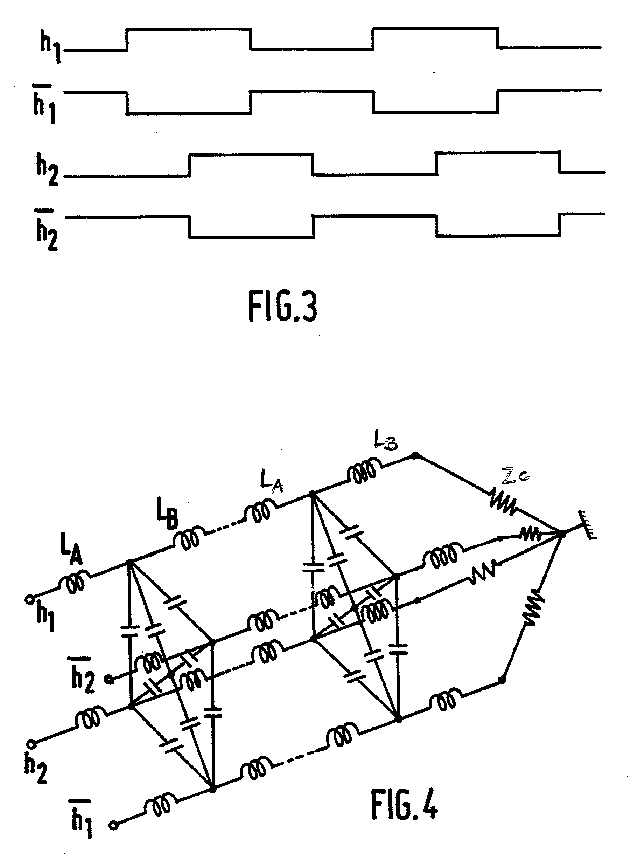

La figure 2 est un schéma électrique équivalent représentant l'interconnexion des capacités Ce et Cs entre elles pour un élément mémoire du DTC. Ce schéma indique la complète symétrie qu'il y a dans l'interconnexion des différentes capacités. Dans le mode habituel de fonctionnement d'un DTC, il existe la particularité que l'horloge h3 est l'inverse de l'horloge h1, de même que l'horloge h4 est l'inverse de l'horloge h2. On a donc h3 = $\overline{h1}$ et h4 = $\overline{h2}$. Les deux horloges h1 et h2 sont décalées dans le temps. Le diagramme des temps est représenté sur la figure 3. En régime dynamique, le schéma équivalent de la figure 2 présente donc une symétrie supplémentaire avec des signaux d'horloges en opposition de phase sur chacune des diagonales représentées.

Un générateur d'horloges h1, h2, $\overline{h1}$, $\overline{h2}$, connecté tel qu'indiqué sur la figure 2, serait chargé sur l'impédance capacitive constituée des k éléments-mémoire mis en série. Pour supprimer cette impédance capacitive vue par le générateur d'horloge, l'invention réalise la connexion des éléments-mémoire entre eux à l'aide d'organes selfiques par exemple de selfs bobinées.

La figure 4 représente le schéma électrique équivalent du DTC ainsi réalisé. Chaque sommet du carré du schéma électrique équivalent précédent, par où transitent les horloges, est relié au sommet suivant analogue à l'aide de selfs. La sortie du dernier élément-mémoire est relié, à travers les selfs de sortie à quatre résistances, égales à l'impédance caractéristique Zc du réseau. Pour obtenir l'impédance caractéristique Zc souhaitée, l'inductance se définit de la manière suivante.

Avec un dispositif à transfert de charges ayant N éléments-mémoire il est possible de regrouper ces N éléments-mémoire en j groupes de transport avec $1 \le j \le N$ comprenant chacun k éléments-mémoire tel que $1 \le k \le N$.

Chaque groupe de transport va ainsi présenter des capacités globales Cej et Csj telles que :
$Cej = Ce \times k$ et $Csj = Cs \times k$.

Pour une impédance caractéristique Zc choisie pour un groupe de transport, la valeur de l'inductance nécessaire pour réaliser les connexions déjà décrites, à l'aide des organes selfiques LA et LB regroupés, est telle que la somme des valeurs des selfs LA et LB est égale à :

$$L = 2 \cdot Zc^2 \cdot k\left(Ce + \frac{Cs}{2}\right).$$

Préférentiellement, la valeur de chaque organe selfique LA ou LB est égale à L/2.

La valeur BW de la bande passante du groupe de transport est alors déterminée par :

$$BW = \frac{1}{2\pi Zc \ (Cej+Csj/2)}.$$

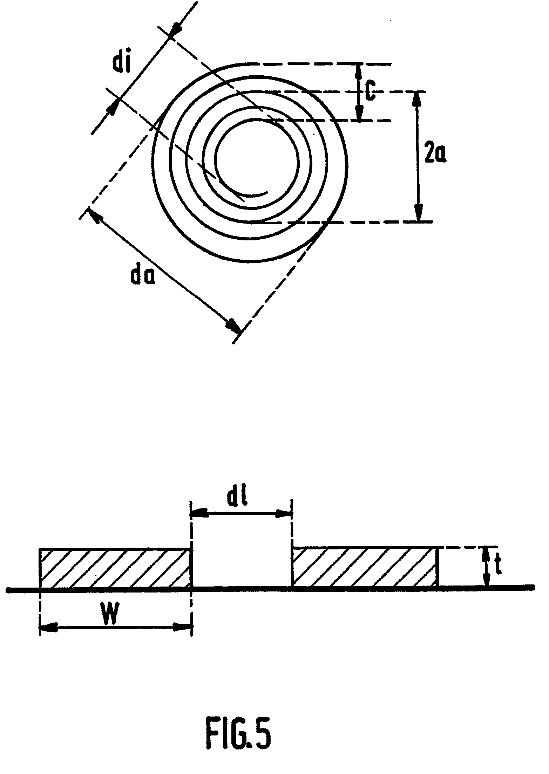

La figure 5 représente un exemple d'organe selfique constitué par une inductance spiralée. Elle est constituée d'un ruban métallique de largeur W et d'épaisseur t, l'espacement entre spires étant dl. La spirale complète va présenter un écartement interne di et un écartement externe da. Le diamètre moyen de la spirale est 2a, l'épaisseur de la spirale est

$$c = \frac{da - di}{2}.$$

La spirale est formée de m révolutions, chaque révolution correspondant à un déplacement angulaire de $2\pi$. La valeur de l'inductance est alors égale a :

$$L(nH) = \frac{m^2 \ a^2}{25(8a + 11c)}.$$

avec a et c exprimés en microns.

Une inductance ayant un écartement externe da = 459 μm a une valeur de 8nH avec les paramètres suivants :
a = 150μm ; c = 150μm ; m = 5 ; dl = 5μm ; w = 20μm ; t = 5μm.

Pour un dispositif à transfert de charges ayant 256 éléments-mémoire et qui présente une capacité totale $Ce_N = NxCe = 10pF$ et $Cs_N = NxCs = 6pF$, en l'organisant en 8 groupes de transport formés de 32 éléments-mémoire, les capacités déja définies pour chaque groupe de transport sont $Cej = 1,25pF$ et $Csj = 0,75pF$. Avec une inductance de L = 8nH associée à chaque plot de contact la largeur de la bande passante est égale à 1,9GHz.

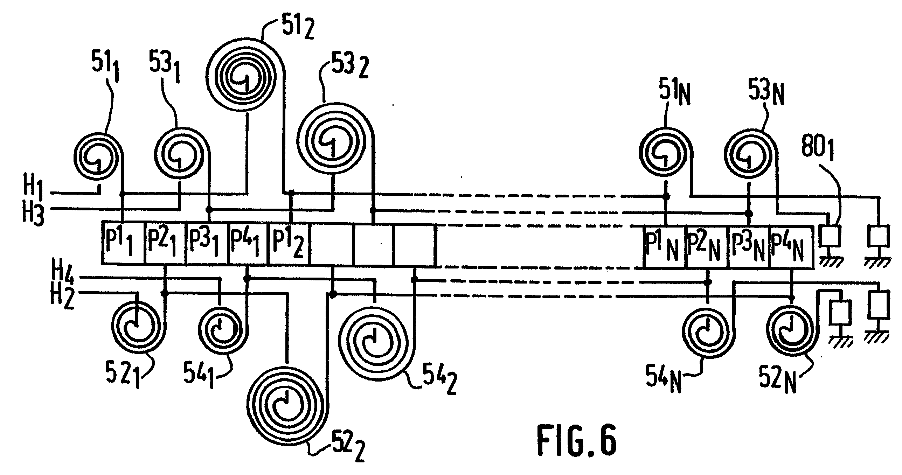

La figure 6 est une représentation de l'interconnexion des organes selfiques avec chaque plot de contact. Considérons le cas de l'horloge H1, une situation semblable s'appliquant aux cas des horloges H2, H3 et H4.

L'horloge H1 issue du générateur d'horloge est reliée à une extrémité de l'organe selfique $51_1$ dont l'autre extrémité est réunie au plot de contact $L1_1$ du premier élément mémoire. Ce plot de contact $p1_1$ est également réuni à une extrémité de l'organe selfique $51_2$ dont l'autre extrémité est reliée au plot de contact $p1_2$ et ainsi de suite. Dans le cas où le dispositif à transfert de charges est réalisé avec N éléments-mémoire le N-ième plot de contact $p1_N$ est relié aux deux organes selfiques $51_{N-1}$ et $51_N$. L'autre extrémité de ce dernier élément est réunie à la masse à travers une résistance de charge $80_1$ égale à l'impédance caractéristique Zc.

Les organes selfiques de $51_2$ à $51_{N-1}$ ont tous sensiblement la même valeur égale à

$$L = 2 \cdot Zc^2 \cdot \left(Ce + \frac{Cs}{2}\right)$$

correspondant à la somme des valeurs de LA et de LB.

Les organes selfiques $51_1$ et $51_N$, respectivement LA et LB, ont une valeur sensiblement égale à L/2.

D'une manière analogue la ligne d'horloge H3 présente les organes selfiques $53_1$ à $53_N$, la ligne d'horloge H2 présente les organes selfiques $51_1$ à $52_N$ et la ligne d'horloge H4 présente les organes selfiques $54_1$ à $54_N$.

Il va de soi que la valeur donnée à L correspond au cas de l'adaptation correcte d'impédance, et qu'une valeur légèrement différente modifiera légèrement les caractéristiques du quadripôle, entraînant une légère baisse de performances du dispositif à transfert de charges, sans pour cela sortir du cadre de l'invention.

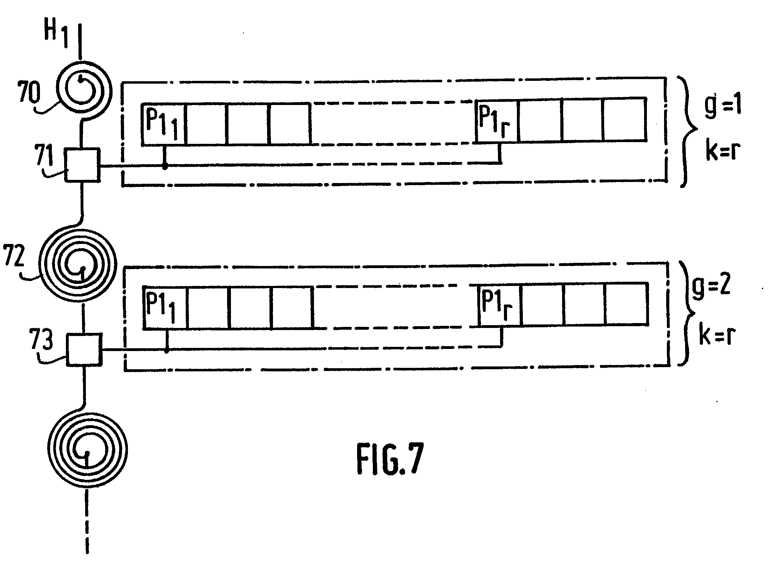

Dans le cas de la figure 6, le DTC est organisé avec j=N et k=1. Dans ce cas chaque organe selfique est relié à 2 plots de contact ou à 1 plot pour les extrémités. Pour réduire le nombre d'organes selfiques, il est possible d'effectuer un regroupement des connexions tel que cela apparaît sur la figure 7.

Deux groupes de transport (g=1 et g=2) sont représentés avec préférentiellement tous deux k=r éléments-mémoire. Comme pour la figure précédente les explications concernent la ligne d'horloge H₁, mais ceci vaut pour les autres horloges. L'ensemble des N éléments-mémoire qui constituent le dispositif à transfert de charges sont donc regroupés en j groupes de transport, chacun ayant k éléments-mémoire. Les plots de contact $p1_1$, $p1_2$, ..., $p1_r$ du groupe g=1 sont reliés entre eux et raccordés à un plot commun 71. De même les plots de contact $p1_1$, $p1_2$, ..., $p1_r$ du groupe g=2 sont reliés entre eux et raccordés à un plot commun 73. On dispose ainsi de j plots communs sur le dispositif à transfert de charges. Tous ces plots communs sont alors reliés entre eux par des organes selfiques d'une manière analogue aux connexions représentées sur la figure 6. Ainsi sur la figure 7, l'horloge H₁ est reliée à une extrémité de l'organe selfique 70, dont l'autre extrémité est reliée au plot commun 71. Celui-ci est à son tour relié à une extrémité de l'organe selfique 72 dont l'autre extrémité est reliée au plot commun 73, et ainsi de suite. Les connexions sont analogues pour les horloges H2, H3 et H4. L'organe selfique situé entre deux plots communs a une valeur d'inductance égale à

$$L = 2 . Zc^2 . r(Ce + \frac{Cs}{2}).$$

Les deux organes selfiques situés aux extrémités ont une valeur L/2.

Avantageusement ces inductances sont réalisées au cours de la même opération que la formation du réseau d'interconnexion. Elles peuvent également être réalisées en technologie couche mince ou couche épaisse sur un support sur lequel est rapporté le circuit intégré monolithique. Les interconnexions sont alors faites par thermocompression ou autres. Ces inductances peuvent être réalisées par l'Homme de métier selon une tout autre forme sans sortir du cadre de l'invention.

Ce dispositif à transfert de charges trouve principalement son application dans les systèmes nécessitant un fonctionnement à fréquence élevée, tels que les dispositifs de traitement du signal, en particulier en oscilloscopie numérique ou en traitement d'images.

## Revendications

1. Dispositif à transfert de charges comprenant N éléments-mémoire ($10n$, $10n+1$), dans lesquels les charges stockées sont transférées à l'aide de 2 ou 4 horloges (h1, ..., h4) issues d'un générateur d'horloges, les 2 ou 4 horloges étant appliquées sur chaque élément-mémoire à l'aide de 2 ou 4 plots de contact ($p1n$, ..., $p4n$), sur chacun desquels apparaissant une capacité Ce entre plots voisins et une capacité Cs entre un plot et le substrat (20) du dispositif à transfert de charges, caractérisé en ce que pour accroître les vitesses de transfert des charges stockées on connecte à chacun des 2 ou 4 plots de contact d'un élément-mémoire une des extrémités de deux organes selfiques LA et LB, de telle sorte que l'autre extrémité de l'organe selfique LB étant chargée par une impédance de nature résistive Zc, l'impédance présentée par l'autre extrémité de l'organe selfique LA soit aussi de nature résistive.

2. Dispositif à transfert de charges selon la revendication 1, caractérisé en ce que les N éléments-mémoire sont organisés en j groupes de transport qui comportent chacun k éléments-mémoire avec $1 \leq j \leq N$ et $N \geq k \geq 1$.

3. Dispositif à transfert de charges selon la revendication 2, caractérisé en ce que les plots de contact contrôlés par une même horloge, sont regroupés entre eux, en chaîne, par groupes de transport, l'autre extrémité de l'organe selfique LB relié à un plot étant réunie à l'autre extrémité de l'organe selfique LA relié au plot suivant, la dernière autre extrémité de l'organe selfique LB de chaque groupe de transport étant réunie à une impédance résistive de charge Zc.

4. Dispositif à transfert de charges selon la revendication 3, caractérisé en ce que pour une même horloge, l'impédance résistive de charge Zc d'un des j groupes de transport est l'impédance caractéristique du quadripôle formé par les organes selfiques LA et LB de valeur sensiblement égale à L/2 et les k capacités de valeurs Ce et Cs, la valeur L/2 des organes selfiques LA et LB étant déterminée par :

$$L/2 = Zc^2 . k(Ce + \frac{Cs}{2})$$

de sorte que la somme des valeurs d'inductance des organes selfiques LA et LB soit égale à L.

5. Dispositif à transfert de charges selon une des revendications 1 à 4, caractérisé en ce que les organes selfiques sont constitués d'un dépôt conducteur.

6. Dispositif à transfert de charges selon la revendication 5, caractérisé en ce que les organes selfiques sont réalisés sur un support et interconnectés au circuit intégré monolithique fixé audit support.

7. Oscilloscope numérique caractérisé en ce qu'il comprend un dispositif à transfert de charges selon une des revendications 1 à 6.

8. Dispositif de traitement d'images caractérisé en ce qu'il comprend un dispositif à transfert de charges selon une des revendications 1 à 6.

## Claims

1. A charge transfer device comprising N memory elements ($10n$, $10n+1$), in which the stored charges are transferred by means of two or four clock signals (h₁...h₄) produced by a clock signal generator, the two or four clock signals being applied to each memory element by means of two or four contact pads ($p1n$, ..., $p4n$), at each of which appears a capacitance Ce between adjacent pads and a capacitance Cs between a pad and the substrate (20) of the charge transfer device, characterized in that, in order to increase the speeds of transferring the stored charges, each of the two or four contact pads of a memory element has connected to it one of the ends of two self-induction members LA and LB in such a manner that, the other end of the self-induction member (LB) being loaded by an impedance of the resistive kind Zc, the impedance presented by the other end of the self-induction member LA is also of the resistive kind.

2. A charge transfer device as claimed in Claim 1, characterized in that the N memory elements are organized in $j$ transport groups which each comprise $k$ memory elements with $1 \leq j \leq N$ and $N \geq k \geq 1$.

3. A charge transfer device as claimed in Claim 2, characterized in that the contact pads controlled by the same clock signal are rearranged mutually in a chain of transport groups, the other end of the self-induction member LB connected to a pad being connected to the other end of the self-induction member LA connected to the following pad, the last other end of the self-induction member LB of each transport group being connected to a resistive load impedance Zc.

4. A charge transfer device as claimed in Claim 3, characterized in that for the same clock signal the resistive load impedance Zc of one of the $j$ transport groups is the characteristic impedance of the quadrupole constituted by the self-induction members LA and LB having a value substantially equal to L/2 and the $k$ capacitances having a value Ce and Cs, the value L/2 of the self-induction members LA and LB being determined by

$$L/2 = Zc^2 . k(Ce + \frac{Cs}{2})$$

so that the sum of the inductance values of the self-induction members LA and LB is equal to L.

5. A charge transfer device as claimed in any one of Claims 1 to 4, characterized in that the self-induction members are constituted by a conductive layer.

6. A charge transfer device as claimed in Claim 5, characterized in that the self-induction members are formed on a support and are interconnected to form the monolithic integrated circuit fixed to the said support.

7. A digital oscilloscope, characterized in that it comprises a charge transfer device as claimed in any one of Claims 1 to 6.

8. An arrangement for handling pictures, characterized in that it comprises a charge transfer device as claimed in any one of the Claims 1 to 6.

**Patentansprüche**

1. Ladungsverschiebeanordnung mit N Speicherelementen (10n, 10n+1), in denen die gespeicherten Ladungen mittels 2 oder 4 von einem Taktimpulssignalgenerator gelieferter Taktimpulssignale (h1, ...h4) verschoben werden, wobei die 2 oder 4 Taktimpulssignale jedem Speicherelement mittels 2 oder 4 Kontaktgebieten (p1n,....p4n) zugeführt werden, wobei an jedem derselben zwischen benachbarten Gebieten eine Kapazität Ce erscheint und zwischen einem Gebiet und dem Substrat (20) der Ladungsverschiebeanordnung eine Kapazität Cs erscheint, dadurch gekennzeichnet, daß zur Steigerung der Verschiebegeschwindigkeiten der gespeicherten Ladungen mit jedem der 2 oder 4 Kontaktgebiete eines Speicherelementes eines der Enden zweier Induktivitäten LA und LB derart verbunden wird, daß das andere Ende der Induktivität LB durch eine Impedanz ohmscher Art Zc geladen wird, wobei die durch das andere Ende des Induktivität LA dargestellte Impedanz ebenfalls ohmscher Art ist.

2. Ladungsverschiebeanordnung nach Anspruch 1, dadurch gekennzeichnet, daß die N Speicherelemente in j Transportgruppen organisiert sind, die je k Speicherelemente mit $1 \leq j \leq N$ und $N \leq k \leq 1$ aufweisen.

3. Ladungsverschiebeanordnung nach Anspruch 2, dadurch gekennzeichnet, daß die von ein und demselben Taktimpulssignal gesteuerten Kontaktgebiete untereinander in einer Folge von Transportgruppen neu gegliedert werden, wobei das andere Ende der mit einem Gebiet verbundenen Induktivität LB mit dem anderen Ende der mit dem nachfolgenden Gebiet verbundenen Induktivität LA verbunden ist, wobei dieses letztere andere Ende der Induktivität LB jeder Transportgruppe mit einer ohmschen Belastungsimpedanz Zc verbunden ist.

4. Ladungsverschiebeanordnung nach Anspruch 3, dadurch gekennzeichnet, daß für ein und denselben Taktimpuls die ohmsche Belastungsimpedanz Zc einer der j Transportgruppen der Wellenwiderstand des durch die Induktivität LA und LB mit dem Wert nahezu gleich L/2 und die k Kapazitäten mit den Werten Ce und Cs gebildeten Vierpols ist, wobei der Wert L/2 der Induktivitäten LA und LB bestimmt wird durch:

$L/2 = Zc^2 . k(Ce + Cs/2)$,

wodurch die Summe der Werte der Induktivitäten LA und LB gleich L sind.

5. Ladungsverschiebeanordnung nach einem der Ansprüche 1 bis 4, dadurch gekennzeichnet, daß die Induktivitäten durch eine leitende Schicht gebildet sind.

6. Ladungsverschiebeanordnung nach Anspruch 5, dadurch gekennzeichnet, daß die Induktivitäten auf einem Träger ausgebildet und mit der auf diesem Träger vorgesehenen monolithischen integrierten Schaltung verbunden sind.

7. Digitales Oszilloskop, dadurch gekennzeichnet, daß dieses eine Ladungsverschiebeanordnung nach einem der Ansprüche 1 bis 6 aufweist.

8. Bildverarbeitungsanordnung, dadurch gekennzeichnet, daß diese eine Ladungsverschiebeanordnung nach einem der Ansprüche 1 bis 6 aufweist.

FIG.1

FIG.2

FIG.3

FIG.4

FIG.5

FIG.6

EP 0 201 970 B1

**FIG.7**

EP 0 201 970 B1